# EUROPEAN PATENT SPECIFICATION

(11) **EP 2 121 459 B1**
(45) Date of publication and mention of the grant of the patent: **29.08.2012**
(21) Application number: 07852130.9
(22) Date of filing: 20.12.2007
(51) Int. Cl.: A47B 47/00, H05K 7/18, B65D 6/16

(54) **RACK FOR TRANSPORT AND STORAGE**
GESTELL FÜR TRANSPORT UND LAGERUNG
RATELIER POUR TRANSPORT ET STOCKAGE

(30) Priority: 03.01.2007 SE 0700004
(43) Date of publication of application: 25.11.2009
(73) Proprietor: Schoeller Arca Systems AB, 284 22 Perstorp (SE)
(72) Inventor: YDSTRÖM, Per, 284 92 Perstop (SE)
(74) Representative: HOFFMANN EITLE
(86) International application number: PCT/SE2007/001132
(87) International publication number: WO 2008/082340

(56) References cited:
- WO-A1-2006/075653
- GB-A- 1 105 664
- US-A1- 2002 184 831
- US-B1- 6 385 050
- US-B1- 6 385 050

## Description

### BACKGROUND OF THE INVENTION

### 1. Field of the invention

The present invention relates to a collapsible rack for transport and storage of flat or semi flat objects.

### 2. Description of related prior art

Racks for keeping flat objects organized and protected during transport and storage is a well known item. These racks are known from a number of different technical fields. We may here mention electronic industry where printed circuit boards with components installed often are stored and transported this way, both during assembly in so called surface mounting lines and for delivery of fully assembled and semi-assembled boards. Racks are also used during curing and similar treatment of the printed circuit board prior to installation of components. One such rack is known from US 4,761,044 showing a rack which have an adjustable width. This will make it possible to adjust the rack for the specific printed circuit board currently in use. Another rack is known from US 5,593,046. This rack is foldable but have a great number of hinges which will make it very difficult to ensure parallelity between the panels carrying the printed circuit boards. It will furthermore be very difficult to ensure that the panels and the arms connecting them relate to one another perpendicular as seen from above. The design is also rather complicated and therefore costly. Since each arm is provided with no less than three hinges, it will become impracticable to obtain any acceptable tolerance.

It is also known to use racks in food industry as for example in bakeries and for trays in restaurants.

In very many cases these racks will have to be transported without carrying any content. It is therefore be beneficial if it was possible to reduce the size of such an empty rack in some way in order to minimize the transport cost. It is of course possible to disassemble a rack and to assemble it again after transport. However, this would require special skill and training of the personnel as well as an increased wear and tear of the different parts would occur. There is also a risk of loosing parts and tolerances in an assembled rack would inevitably be hampered. It is in many cases important to uphold narrow tolerances as well as stability since especially electronic components can be rather valuable as well as sensitive.

US-A-6,385,050 discloses a collapsible rack according to the preamble of claim 1.

### SUMMARY OF THE INVENTION

The present invention aims at solving the above problems by providing a collapsible rack which minimizes the number of moveable parts and ensures a stabile carrier for sensitive components. It has through the present invention been made possible to solve the above problems and a collapsible, sturdy and cost effective rack has been brought about.

Accordingly, the present invention relates to a collapsible rack for transport and storage. The collapsible rack is provided with a first and a second panel and a plurality of distance bars. The first and second panel have a groove side provided with at least one groove, a first and a second edge arranged on opposite sides and adjacent to these, a third and a fourth edge. The invention is characterized in that the third and fourth edges are provided with each at least one hole which extends parallel to the first and second edges. This hole have a non-circular shape. The distance bars are at each of its ends provided with a hole coupling means. The hole coupling means extends perpendicular to the extension of the bar and the hole coupling means are provided with clutching sections which matches the hole. Pivoting between the bars and the first and second panel is prevented through the non-circular shape of the hole when the matching hole coupling means and hole is fully mated. The non-circular shaped hole is then so shaped that the clutching section is prevented from rotating around its axis of extension when in a clutched position. Accordingly, the non-circular shaped hole have a hole wall surface with a non-constant radius. It is possible to provide the non-circular shaped hole with a number of different shapes of which we may mention; triangular, oblong, quadratic, rectangular, pentagonal, hexagonal, star-shaped, provided with splines, provided with ribs, provided with satellites and a combination thereof. Most shapes are self explanatory but a few will need some clarification. A hole provided with ribs may actually have a mainly circular shape but is provided with one or more axial ribs, and as defined the clutching section is so shaped that it match this hole shape. A hole with satellites can also be circular and is provided with one or more further holes outside this main hole. Needless to say, the clutching section is then shaped to match this design.

The coupling means are provided with a pivoting section arranged on the end of clutching section. The coupling means are preferably also provided with a spring which have the purpose of pulling the clutching section into interaction with the hole. The operator will then only have to pull the two distance bars apart to fold an emptied rack. It is of course advantageous to provide the coupling means with a stopper which limits the distance it can be pulled out.

The distance bar preferably comprises a bar section and two end sections. The bar section slides into a bar hole on each of the end sections. This allows the rack to easily be designed for the desired printed circuit board width by only changing the bar section. The end sections are suitably provided with a locking hole and a lock screw arranged perpendicular to the bar section. This allows the width of the rack to be locked after having been adjusted to exact width. The screw may have a conical tip which is pressed into the face of the bar section. The threads in the locking hole are suitably tight enough to prevent the screw from getting loose. It also possible to lock the screw with cyanoacrylate glue or the like. It is finally suitable to use a cap to cover the open end of the locking hole to prevent unauthorized tampering with the locking screw. This cap may even be molded together with, and attached to, the end section via a so-called live hinge

The clutching sections are preferably tapered and the hole is also tapered to match the clutching section. This will minimize any play in the rack which otherwise would be wobbly. Wear and tear will not have effect on such a design and the stability will be kept within the desired range for a very long time. The taper is suitably larger than 1° as seen from the insertion axis. Accordingly, both the hole and the clutching section have a conical shape and the angle of the side faces are adapted so that the parts do not wedge hard enough to cause problems. The angle should be adapted to the material selected, but normally an angle above 2 - 4° should be without problems.

The first and second panels are suitably provided with a channel which runs between the third and fourth edges as well as parallel to the first and second edges and ends with the holes on said third and fourth edges. This channel is then suitably arranged adjacent to the first edge. This cannel may suitably be so designed that an end plug containing the hole intended to match the clutching section is inserted in the end of the channel. It will hereby be a rather simple task to insert a spring between the two opposite clutching sections, pulling the two together. It is also rather easy to insert a stopper in the form of a washer or a pin on the inside of the end plug which, as desired, limits the outward movement of the clutching section.

According to a preferred embodiment of the invention a second channel is arranged adjacent to the second edge. This second channel is then arranged parallel to the second edge. The second channel suitably ends with a guiding hole. This hole may be fully circular, in fact it is advantageous to design it this way since it then will not have to be manipulated during folding. Accordingly, the locking in erect position will be taken care of by the clutching section and hole described above. The guiding hole is then intended to receive couplers of secondary distance bars. The couplers are suitably provided with a spring which have the purpose of pulling the couplers into interaction with the guiding hole. The secondary distance bar preferably comprises a bar section and two end sections wherein the bar section slides into a bar hole on each of the end sections. The end sections are suitably provided with a locking hole and a lock screw arranged perpendicular to the bar section. The couplers are, like for the clutching section described above and of the same reason, tapered and the guiding hole is also tapered to match the couplers. The taper is also here larger than 1° as seen from the insertion axis and is subject of the same considerations as discussed over the clutching section above.

The collapsible rack is suitably, in the main, manufactured of a polymeric material selected from the group consisting of; polyethylene, polypropylene, polybutene, polyvinylchloride, polyalkylenetherephtalate, acrylonitrilebutadienestyrenecopolymer, polyamide, polycarbonate, polyethersulphone and combinations thereof, through injection molding, vacuum molding, blow molding, extrusion and combinations thereof. The polymeric material may further contains a filler selected from the group consisting of; carbon black, fiber glass, carbon fiber, aramide fiber, steel fiber and combinations thereof. As should be understood by the above certain parts like screws, pins, washers may be manufactured of any suitable material. It is, for example advantageous to manufacture the bar section of aluminum or magnesium through means of extrusion or injection molding. It is also possible to manufacture the distance bar and secondary distance bar entirely of aluminum or magnesium through injection molding. In cases where the rack is used for transporting and/or storage of esd sensitive printed circuit boards it is advantageous to use leading materials to a level which fulfills the requirements for esd secured equipment. This is achieved by using metal components and/or polymeric components with a defined amount of filler of carbon black and/or carbon fiber.

### DESCRIPTION OF AN EMBODIMENT EXAMPLE

The invention is described further in connection to enclosed figures showing different embodiments of the invention whereby,
- figure 1 shows, in perspective view, a collapsible rack 1 according to the invention.
- figure 2 shows, in perspective blown view, an upper portion of a collapsible rack 1 according to the invention where a clutching section 36 and a hole 25 is parted.
- figure 3 shows, in perspective blown view, an lower part of a collapsible rack 1 according to the invention where a coupler 35^{I} and a coupler hole 25^{B} is parted.

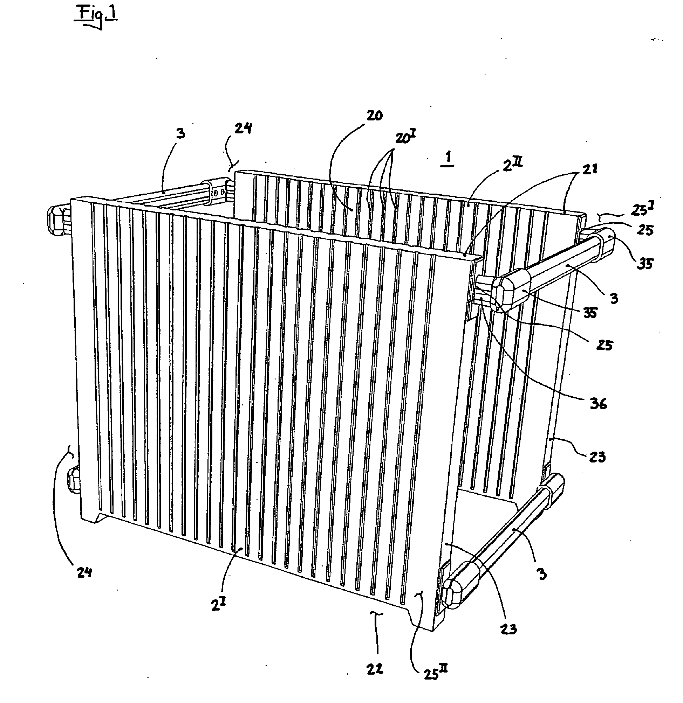

Accordingly, figure 1 shows a collapsible rack 1 for transport an storage. The collapsible rack 1 is provided with a first and a second panel 2^{I} and 2^{II} respectively and a plurality of distance bars 3. The first and second panel 2^{I} and 2^{II} respectively, have a groove side 20 provided with a number of grooves 20^{I} intended for receiving printed circuit boards. The panels 2^{I} and 2^{II} respectively have first and second edges 21 and 22 respectively, arranged on opposite sides and adjacent to these, third and a fourth edges 23 and 24 respectively. The first and second panels 2^{I} and 2^{II} respectively are provided with a channel 25' (hidden) which runs between the third and fourth edges 23 and 24 respectively as well as parallel to the first and second edges 21 an 22 respectively and ends with the holes 25 on said third and fourth edges 23 and 24 respectively. The channel 25^{I} is arranged adjacent to the first edge 21. Accordingly, the holes 25 extends parallel to the first and second edges 21 and 22 respectively. These holes 25 have a non-circular shape. The distance bars 3 are at each of its ends provided with a hole coupling means 35. The hole coupling means 35 extends perpendicular to the extension of the bar 3. The hole coupling means are provided with clutching sections 36 which matches the hole 25 so that pivoting between the bars 3 and the first and second panel 2^{I} and 2^{II} respectively is prevented once the hole coupling means 35 and holes 25 are fully mated. The distance bars 3 are pulled out of engagement in figure 1.

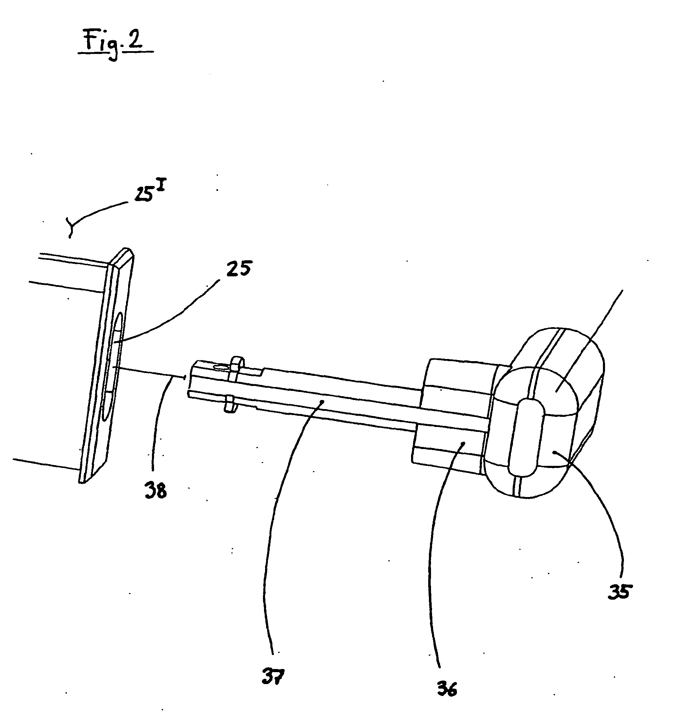

Referring now to figure 2. The coupling means 35 are provided with a pivoting section 37 arranged on the end of clutching section 36. Accordingly, once the clutching section 36 is pulled out of engagement with the hole 25, the distance bar 3 is free to pivot. The coupling means 35 are provided with a spring 38 which have the purpose of pulling the clutching section 36 into interaction with the hole 25. This spring 38 is hidden in the channel 25^{I}.

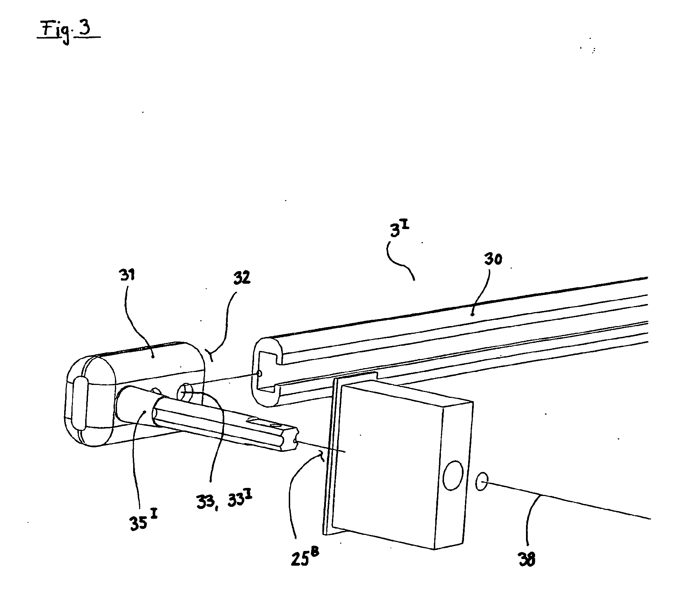

Referring now to figure 3 which shows a secondary distance bar 3^{I}. These are similar to the distance bars 3 in that they comprises a bar section 30 and two end sections 31. The bar section 30 slides into a bar hole 32 on each of the end sections 31. The end sections 31 are provided with a locking hole 33 and a lock screw 33^{I} arranged perpendicular to the bar section 30.

Referring again to figure 2 showing the clutching sections 36 which are tapered and the hole 25 is also tapered to match the clutching section 36. The taper is 4° as seen from the insertion axis.

As best viewed in figure 1, a second channel 25" (hidden) is arranged adjacent to the second edge 22. The second channel 25" is arranged parallel to the second edge 22. As can be seen in figure 3 the second channel 25" ends with a guiding hole 25^{B}.

The guiding hole 25^{B} is intended to receive couplers 35^{I} of secondary distance bars 3^{I}. The couplers 35^{I} are provided with a spring 38 which have the purpose of pulling the couplers 35^{I} into interaction with the guiding hole 25^{B}. This spring 38 is hidden in the channel 25". Like the distance bars 3, the secondary distance bar 3^{I} comprises a bar section 30 and two end sections 31. The bar section 30 slides into a bar hole 32 on each of the end sections 31. The end sections 31 are provided with a locking hole 33 and a lock screw 33^{I} arranged perpendicular to the bar section 30. The couplers 35^{I} are tapered and the guiding hole 25^{B} is also tapered to match the couplers 35^{I}. The angle is 4° as seen from the insertion axis.

Most parts of the rack 1 is manufactured of polyamide reinforced with fiber glass and filled with carbon black for conductivity. The later is used for providing protection from electrostatic discharge.

The invention is not limited by the embodiments shown since these can be varied in different ways within the scope of the invention.

## Claims

1. Collapsible rack (1) for transport and storage, wherein
the collapsible rack (1) is provided with a first (2^{I}) and a second panel (2^{II}) and a plurality of distance bars (3) , and
the first (2^{I}) and the second panel (2^{II}) have a groove side (20) provided with at least one groove (20^{I}), a first (21) and a second edge (22) arranged on opposite sides, and adjacent to these a third (23) and a fourth edge (24),
**characterized in that**
the third (23) and fourth edges (24) are each provided with at least one hole (25) which extends parallel to the first (21) and second edges (22), said holes (25) having a non-circular shape, and
the distance bars (3) are at each of their ends provided with a hole coupling means (35) which extends perpendicular to the extension of the bar (3) and which is provided with a clutching section (36) matching with one of the holes (25),
wherein a pivoting section (37) is arranged on the end of the clutching section (36), and pivoting between the bars (3) and the first (2^{I}) and the second panel (2^{II}) is prevented when the hole coupling means (35) and the holes (25) are fully mated, and
the coupling means (35) are further provided with a spring (38) which is arranged for pulling the clutching section (36) into interaction with the hole (25).

2. Collapsible rack (1) according to claim 1, wherein the distance bar (3) comprises a bar section (30) and two end sections (31), and the bar section (30) is slidably arranged within bar holes (32) formed in each of the end sections (31), wherein each of the end sections (31) is provided with a locking hole (33) and a lock screw (33^{I}) arranged perpendicular to the bar section (30).

3. Collapsible rack (1) according to claim 1, wherein the clutching sections (36) are tapered and the holes (25) are also tapered to match the clutching sections (36), wherein the taper is preferably larger than 1° as seen from the insertion axis.

4. Collapsible rack (1) according to claim 1, wherein the first (2^{I}) and second panels (2^{II}) are each provided with a channel (25^{I}) which runs between the third (23) and fourth edges (24) as well as parallel to the first (21) and second edges (22) and ends with the holes (25) on said third (23) and fourth edges (24) , wherein the channel (25^{I}) is arranged adjacent to the first edge (21), and wherein a second channel (25^{II}) is arranged adjacent to the second edge (22).

5. Collapsible rack (1) according to claim 4, wherein the second channel (25^{II}) is arranged parallel to the fourth edge (24), the second channel (25^{II}) ends with a guiding hole (25^{B}), the guiding hole (25^{B}) is arranged for receiving couplers (35^{I}) of secondary distance bars (3^{I}), and the couplers (35^{I}) are preferably each provided with a spring (38) which is arranged for pulling the couplers (35^{I}) into interaction with the guiding hole (25^{B}).

6. Collapsible rack (1) according to claim 5, wherein the secondary distance bar (3^{I}) comprises a bar section (30) and two end sections (31), and the bar section (30) is slidably arranged within bar holes (32) formed in each of the end sections (31), wherein the end sections (31) are each provided with a locking hole (33) and a lock screw (33^{I}) arranged perpendicular to the bar section (30).

7. Collapsible rack (1) according to claim 1, wherein the couplers (35^{I}) are tapered and the guiding holes (25^{B}) are also tapered to match the couplers (35^{I}).

8. Collapsible rack (1) according to claim 7, wherein the taper is larger than 1° as seen from the insertion axis.

9. Collapsible rack (1) according to any of the claims 1 to 8, wherein it, in the main, is manufactured of a polymeric material selected from the group consisting of polyethylene, polypropylene, polybutene, polyvinylchloride, polyalkylenetherephtalate, acrylonitrilebutadienestyrene copolymer, polyamide, polycarbonate, polyethersulphone and combinations thereof, through injection molding, vacuum molding, blow molding, extrusion or a combination thereof, wherein the polymeric material preferably further contains a filler selected from the group consisting of carbon black, fiber glass, carbon fiber, aramide fiber, steel fiber and combinations thereof.

10. Collapsible rack (1) according to any of claims 2 or 6, wherein the bar section (30) is manufactured of a metal selected from the group consisting of aluminum and magnesium through means of a method selected from the group consisting of extrusion and injection molding.

11. Collapsible rack (1) according to claim 5, wherein the distance bar (3) and the secondary distance bar (3^{I}) are manufactured of a metal selected from the group consisting of aluminum and magnesium by injection molding.

12. Collapsible rack (1) according to claim 1, wherein each of the non-circular shaped hole (25) is so shaped that the clutching section (36) is prevented from rotating around its axis of extension when in a clutched position.

13. Collapsible rack (1) according to claim 11, wherein each of the non-circular shaped holes (25) has a hole wall surface with a non-constant radius.

14. Collapsible rack (1) according to claim 12, wherein each of the non-circular shaped holes (25) is provided with a shape selected from the group consisting of triangular, oblong, quadratic, rectangular, pentagonal, hexagonal, star-shaped, provided with splines, provided with ribs, provided with satellites and combinations thereof.

## Patentansprüche

1. Zusammenlegbares Gestell (1) zum Transport und zur Aufbewahrung,
das mit einer ersten (2^{I}) und einer zweiten Platte (2^{II}) und mehreren Abstandsstäben (3) versehen ist und bei dem
die erste (2^{I}) und die zweite Platte (2^{II}) eine Nutseite (20) mit zumindest einer Nut (20^{I}), einen ersten (21) und einen zweiten Rand (22), die an gegenüberliegenden Seiten angeordnet sind, und angrenzend an diese einen dritten (23) und einen vierten Rand (24) aufweisen,
**dadurch gekennzeichnet, dass**
der dritte (23) und vierte Rand (24) jeweils mit zumindest einer Öffnung (25) versehen sind, die sich parallel zu dem ersten (21) und dem zweiten Rand (22) erstreckt, wobei die Öffnungen (25) eine nicht-kreisförmige Form aufweisen, und
die Abstandsstäbe (3) an jedem ihrer Enden mit einem Öffnungskopplungsmittel (35) versehen sind, das sich senkrecht zu der Erstreckung des Stabs (3) erstreckt und das mit einem Kupplungsabschnitt (36) versehen ist, der zu einer der Öffnungen (25) passt,
wobei ein Drehgelenksabschnitt (37) an dem Ende des Kupplungsabschnitts (36) angeordnet ist und Drehen zwischen den Stäben (3) und der ersten (2^{I}) und der zweiten Platte (2^{II}) verhindert wird, wenn das Öffnungskopplungsmittel (35) und die Öffnungen (25) vollständig ineinandergreifen, und
die Kopplungsmittel (35) ferner mit einer Feder (38) versehen sind, die so angeordnet ist, dass der Kupplungsabschnitt (36) in ein Zusammenspiel mit der Öffnung (25) gezogen wird.

2. Zusammenlegbares Gestell (1) nach Anspruch 1, bei dem der Abstandsstab (3) einen Stababschnitt (30) und zwei Endabschnitte (31) aufweist und der Stababschnitt (30) gleitbar innerhalb von Staböffnungen (32) angeordnet ist, die in jedem der Endabschnitte (31) ausgebildet sind, wobei jeder der Endabschnitte (31) mit einer Arretierungsöffnung (33) und einer Arretierschraube (33^{I}) versehen ist, die senkrecht zu dem Stababschnitt (30) angeordnet ist.

3. Zusammenlegbares Gestell (1) nach Anspruch 1, bei dem sich die Kupplungsabschnitte (36) verjüngen und sich die Öffnungen (25) ferner derart verjüngen, dass sie zu den Kupplungsabschnitten (36) passen, wobei die Verjüngung vorzugsweise größer als 1° ist, wie von der Einsetzachse betrachtet.

4. Zusammenlegbares Gestell (1) nach Anspruch 1, bei dem die erste (2^{I}) und zweite Platte (2^{II}) jeweils mit einem Kanal (25^{I}), der zwischen dem dritten (23) und vierten (24) Rand als auch parallel zu dem ersten (21) und zweiten Rand (22) verläuft und mit den Öffnungen (25) an dem dritten (23) und vierten Rand (24) endet, wobei der Kanal (25^{I}) angrenzend an den ersten Rand (21) angeordnet ist und wobei ein zweiter Kanal (25^{II}) angrenzend an den zweiten Rand (22) angeordnet ist.

5. Zusammenlegbares Gestell (1) nach Anspruch 4, bei dem der zweite Kanal (25^{II}) parallel zu dem vierten Rand (24) angeordnet ist, der zweite Kanal (25^{II}) mit einer Führungsöffnung (25^{B}) endet, die Führungsöffnung (25^{B}) zum Aufnehmen von Kopplungen (35^{I}) von sekundären Abstandsstäben (3^{I}) angeordnet ist und die Kopplungen (35^{I}) vorzugsweise jeweils mit einer Feder (38) versehen sind, die zum Ziehen der Kopplungen (35^{I}) in ein Zusammenspiel mit der Führungsöffnung (25B) angeordnet ist.

6. Zusammenlegbares Gestell (1) nach Anspruch 5, bei dem der sekundäre Abstandsstab (3^{I}) einen Stababschnitt (30) und zwei Endabschnitte (31) aufweist und der Stababschnitt (30) gleitbar innerhalb von Staböffnungen (32) angeordnet ist, die in jedem der Endabschnitte (31) ausgebildet sind, wobei jeder der Endabschnitte jeweils mit einer Arretierungsöffnung (33) und einer Arretierschraube (33^{I}) versehen ist, die senkrecht zu dem Stababschnitt (30) angeordnet ist.

7. Zusammenlegbares Gestell (1) nach Anspruch 1, bei dem sich die Kopplungen (35^{I}) verjüngen und sich ferner die Führungsöffnungen (25^{B}) verjüngen, sodass sie zu den Kopplungen (35^{I}) passen.

8. Zusammenlegbares Gestell (1) nach Anspruch 7, bei dem die Verjüngung größer als 1° ist, wie von der Einsetzachse betrachtet.

9. Zusammenlegbares Gestell (1) nach einem der Ansprüche 1 bis 8, das hauptsächlich aus einem Polymermaterial ausgewählt aus der Gruppe bestehend aus Polyethylen, Polypropylen, Polybuten, Polyvinylchlorid, Polyalkylen-Terephthalat, Acrylnitrilbutadienstyrol-Copolymer, Polyamid, Polycarbonat, Polyethersulfon und Kombinationen daraus hergestellt ist, und zwar durch Spritzgießen, Vakuumformen, Blasformen, Extrudieren oder einer Kombination daraus, wobei das Polymermaterial vorzugsweise ferner einen Füllstoff ausgewählt aus der Gruppe bestehend aus Ruß, Glasfaser, Karbonfaser, Aramidfaser, Stahlfaser und Kombinationen daraus enthält.

10. Zusammenlegbares Gestell (1) nach einem der Ansprüche 2 oder 6, bei dem der Stababschnitt (30) aus einem Metall ausgewählt aus der Gruppe bestehend aus Aluminium und Magnesium mittels eines Verfahrens ausgewählt aus der Gruppe bestehend aus Extrudieren und Spritzgießen hergestellt ist.

11. Zusammenlegbares Gestell (1) nach Anspruch 5, bei dem der Abstandsstab (3) und der sekundäre Abstandsstab (3^{I}) aus einem Metall ausgewählt aus der Gruppe bestehend aus Aluminium und Magnesium durch Spritzgießen hergestellt sind.

12. Zusammenlegbares Gestell (1) nach Anspruch 1, bei dem jede der nicht-kreisförmigen Öffnungen (25) so geformt ist, dass verhindert wird, dass der Kupplungsabschnitt (36) um seine Erstreckungsachse rotiert, wenn er in einer gekuppelten Position ist.

13. Zusammenlegbares Gestell (1) nach Anspruch 11, bei dem jede der nicht-kreisförmigen Öffnungen (25) eine Öffnungswandoberfläche mit einem nicht-konstanten Radius aufweist.

14. Zusammenlegbares Gestell (1) nach Anspruch 12, bei dem jede der nicht-kreisförmigen Öffnungen (25) mit einer Form ausgewählt aus der Gruppe bestehend aus dreieckig, länglich, quadratisch, rechtwinklig, fünfeckig, sechseckig, sternförmig, versehen mit Rillen, versehen mit Rippen, versehen mit Satelliten und Kombinationen davon versehen ist.

## Revendications

1. Râtelier démontable (1) pour le transport et le stockage, dans lequel
le râtelier démontable (1) est doté d'un premier (2^{I}) et d'un deuxième panneau (2^{II}) et d'une pluralité de barres d'écartement (3), et
le premier (2^{I}) et le deuxième panneau (2^{II}) ont un côté rainure (20) doté d'au moins une rainure (20^{I}), un premier (21) et un deuxième bord (22) disposés sur des côtés opposés, et adjacents à un troisième (23) et un quatrième bord (24),
**caractérisé en ce que**
les troisième (23) et quatrième bords (24) sont dotés chacun d'au moins un trou (25) qui s'étend parallèlement aux premier (21) et deuxième bords (22), lesdits trous (25) ayant une forme non circulaire, et
les barres d'écartement (3) sont dotées, au niveau de chacune de leurs extrémités, d'un moyen de couplage (35) de trous qui s'étend perpendiculairement jusqu'à l'extension de la barre (3) et qui est doté d'une section d'embrayage (36) correspondant à l'un des trous (25),
dans lequel une section de pivotement (37) est disposée sur l'extrémité de la section d'embrayage (36), et le pivotement entre les barres (3) et le premier (2^{I}) et le deuxième panneau (2^{II}) est empêché lorsque le moyen de couplage (35) de trous et les trous (25) sont complètement accouplés, et
les moyens de couplage (35) sont en outre dotés d'un ressort (38) qui est agencé pour tirer la section d'embrayage (36) en interaction avec le trou (25).

2. Râtelier démontable (1) selon la revendication 1, dans lequel la barre d'écartement (3) comprend une section (30) de la barre et deux sections d'extrémité (31), et la section (30) de la barre est agencée en coulissement dans des trous (32) de la barre formés dans chacune des sections d'extrémité (31), où chacune des sections d'extrémité (31) est dotée d'un trou de verrouillage (33) et d'une vis de blocage (33^{I}) disposés perpendiculairement à la section (30) de la barre.

3. Râtelier démontable (1) selon la revendication 1, dans lequel les sections d'embrayage (36) sont coniques et les trous (25) sont également coniques afin de correspondre aux sections d'embrayage (36), où la conicité est de préférence supérieure à 1° lorsqu'on regarde à partir de l'axe d'insertion.

4. Râtelier démontable (1) selon la revendication 1, dans lequel les premier (2^{I}) et deuxième (2^{II}) panneaux sont dotés chacun d'un canal (25^{I}) qui s'étend entre les troisième (23) et quatrième bords (24) ainsi que parallèlement aux premier (21) et deuxième (22) bords et qui se termine avec les trous (25) sur lesdits troisième (23) et quatrième bords (24), où le canal (25^{I}) est disposé de manière adjacente au premier bord (21), et où un deuxième canal (25^{II}) est disposé de manière adjacente au deuxième bord (22).

5. Râtelier démontable (1) selon la revendication 4, dans lequel le deuxième canal (25^{II}) est disposé parallèlement au quatrième bord (24), le deuxième canal (25^{II}) se termine avec un trou de guidage (25^{B}) , le trou de guidage (25^{B}) est agencé pour recevoir des coupleurs (35^{I}) de barres d'écartement secondaires (3^{I}), et les coupleurs (35^{I}) sont de préférence dotés chacun d'un ressort (38) qui est agencé pour tirer les coupleurs (35^{I}) en interaction avec le trou de guidage (25^{B}).

6. Râtelier démontable (1) selon la revendication 5, dans lequel la barre d'écartement secondaire (3^{I}) comprend une section (30) de la barre et deux sections d'extrémité (31), et la section (30) de la barre est agencée en coulissement dans des trous (32) de la barre formés dans chacune des sections d'extrémité (31), où les sections d'extrémité (31) sont dotées chacune d'un trou de verrouillage (33) et d'une vis de blocage (331) disposés perpendiculairement à la section (30) de la barre.

7. Râtelier démontable (1) selon la revendication 1, dans lequel les coupleurs (35^{I}) sont coniques et les trous de guidage (25^{B}) sont également coniques afin de correspondre aux coupleurs (35^{I}).

8. Râtelier démontable (1) selon la revendication 7, dans lequel la conicité est supérieure à 1° lorsqu'on regarde à partir de l'axe d'insertion.

9. Râtelier démontable (1) selon l'une des revendications 1 à 8, dans lequel, en général, il est fabriqué en un matériau polymère choisi du groupe constitué du polyéthylène, du polypropylène, du polybutène, du polychlorure de vinyle, du polyalkylène-téréphtalate, du copolymère d'acrylonitrile butadiène styrène, du polyamide, du polycarbonate, du polyéthersulfone et de leurs combinaisons, par : moulage par injection, moulage sous vide, moulage par soufflage, extrusion ou leurs combinaison, où le matériau polymère contient en outre de préférence une charge choisie du groupe constitué du noir de carbone, de la fibre de verre, de la fibre de carbone, de la fibre d'aramide, de la fibre d'acier et de leurs combinaisons.

10. Râtelier démontable (1) selon l'une des revendications 2 ou 6, dans lequel la section (30) de la barre est fabriquée en un métal choisi du groupe constitué de l'aluminium et du magnésium par un procédé choisi du groupe constitué de l'extrusion et du moulage par injection.

11. Râtelier démontable (1) selon la revendication 5, dans lequel la barre d'écartement (3) et la barre d'écartement secondaire (3^{I}) sont fabriquées en un métal choisi du groupe constitué de l'aluminium et du magnésium par moulage par injection.

12. Râtelier démontable (1) selon la revendication 1, dans lequel chacun des trous de forme non circulaire (25) est formé de sorte que la section d'embrayage (36) soit empêchée de tourner autour de son axe d'extension lorsqu'elle elle est dans une position embrayée.

13. Râtelier démontable (1) selon la revendication 11, dans lequel chacun des trous de forme non circulaire (25) présente une surface de paroi du trou avec un rayon non constant.

14. Râtelier démontable (1) selon la revendication 12, dans lequel chacun des trous de forme non circulaire (25) est doté d'une forme choisie du groupe constitué des formes : triangulaire, oblongue, quadratique, rectangulaire, pentagonale, hexagonale, en étoile, dotée de cannelures, dotée de nervures, dotée de satellites et leurs combinaisons.
